# EUROPÄISCHE PATENTSCHRIFT

(11) **EP 1 359 662 B1**
(45) Veröffentlichungstag und Bekanntmachung des Hinweises auf die Patenterteilung: **21.06.2006**
(21) Anmeldenummer: 03009489.0
(22) Anmeldetag: 26.04.2003
(51) Int. Cl.: H02M 7/00, H05K 7/14

(54) **Antriebssystem mit Umrichtersteuerung für Niederspannungs-Drehstrommotoren**
Drive system with converter control circuit for low voltage 3-phase motor
Système d'entrainement pour moteur triphasé basse tension avec commande de convertisseur

(30) Priorität: 04.05.2002 DE 10220047
(43) Veröffentlichungstag der Anmeldung: 05.11.2003
(73) Patentinhaber: Jungheinrich Aktiengesellschaft, 22047 Hamburg (DE)
(72) Erfinder: Bergmann, Ulf, Dipl.-Ing., 24558 Wakendorf II (DE); Hansen, Nils-Peter, Dipl.-Ing., 24114 Kiel (DE); Hörmann, Frank, Dipl.-Ing., 24259 Westensee (DE); Jonas, Benjamin, Dipl.-Ing., 24558 Henstedt-Ulzburg (DE); Knieriem, Michael, Dipl.-Ing., 22844 Norderstedt (DE); Lenz, Olaf, Dipl.-Ing., 22339 Hamburg (DE); Schwarz, Rüdiger, Dipl.-Ing., 25451 Quickborn (DE)
(74) Vertreter: Hauck, Graalfs, Wehnert, Döring, Siemons

(56) Entgegenhaltungen:
- EP-A- 0 356 991
- EP-A- 1 035 639
- EP-A- 1 109 431
- EP-A- 1 119 899
- US-A- 6 091 604
- US-A1- 2001 012 212

## Beschreibung

Die Erfindung bezieht sich auf ein Antriebssystem mit Umrichtersteuerung für Niederspannungs-Drehstommotoren nach dem Oberbegriff des Patentanspruchs 1.

Bei Verwendung von Drehstrommotoren für batteriebetriebene Flurförderzeuge ist naturgemäß ein Umformer erforderlich, der die 3-Phasen-Wechselspannung für den Drehstrommotor aus der Batteriespannung erzeugt. Der Umformer enthält üblicherweise drei Halbbrücken, in denen jeweils zwei Halbleiterschalter in Form von Leistungstransistoren angeordnet sind, z. B. MOSFETs oder auch IGBT. Der Umformer weist einen Leistungsteil auf mit Leistungstransistoren zur Erzeugung einer dreiphasigen Ausgangswechselspannung, eine Kondensatorbatterie als Pufferkapazität und einer Ansteuerelektronik für die Leistungstransistoren. Ferner ist ein Steuerteil vorgesehen, welcher ein Rechenteil mit zugehöriger Software aufweist. Sowohl Leistungs- als auch Steuerteile sind üblicherweise auf einer Schaltplatine angeordnet. Die Leistungstransistoren erzeugen eine erhebliche Wärme, die naturgemäß mit Hilfe entsprechender Kühlkörper oder dergleichen an die Umgebung abzugeben ist.

Aus DE 197 20 695 ist ein Umformer bekannt geworden, bei dem alle Leistungstransistoren parallel geschaltete Halbleiterzweige der Drehstrombrücke auf einer ersten Stromschiene angeordnet sind und die Leistungstransistoren des jeweils anderen Halbzweiges der Brücke pro Phase auf einer gesonderten Stromschiene angeordnet sind, an der die jeweilige Phasenspannung abgenommen wird. Die Leistungstransistoren stehen in unmittelbarem thermischen Kontakt mit den Stromschienen, die gleichzeitig Teil eines Kühlkörpers sind.

Aus DE 199 10 787 ist ein Umformer bekannt geworden, bei dem der Kühlkörper drei parallel im Abstand angeordnete längliche Abschnitte aufweist, wobei die Transistoren jeder Phase abwechselnd nebeneinander isoliert an einem Abschnitt angebracht sind. In den beiden Fächern zwischen den Kühlkörperabschnitten sind Platinenabschnitte angeordnet, mit denen die Transistoren und die Kondensatoren der Kondensatorbatterie verbunden sind, wobei der in dem breiteren Fach angeordnete Platinenabschnitt zwei Reihen von Transistoren aufweist. Nahe den Reihen von Transistoren ist jeweils eine Anordnung aus drei parallelen und im Abstand verlaufenden Stromschienen vorgesehen, von denen eine erste Stromschiene für eine Phase, eine zweite Stromschiene für das Minus- und eine dritte Stromschiene für das Plus-Potential vorgesehen sind.

Aus US 2001/012212 A1 ist ein Antriebssystem mit Umrichtersteuerung für Niederspannung für Drehstrommotoren bekannt geworden, bei dem Leistungsteil und Ansteuerteil in einem gemeinsamen Gehäuse aus wärmeleitendem Material untergebracht sind. Das Leistungsteil weist eine erste Leiterplatte aus gut wärmeleitendem Material auf, die in flächiger Anlage auf dem gut wärmeleitenden Boden des Gehäuses angeordnet ist. Das Ansteuerteil enthält eine zweite Leiterplatte, die mit Hilfe von an der ersten Leiterplatte angelöteten Kontaktstiften aus metallischem Material im Abstand zur ersten Leiterplatte mit dieser elektrisch verbunden sind. Die Leiterplatten sind mit Hilfe von wärmeleitenden Trägerplatten mit dem Gehäuse bzw. dem Boden des Gehäuses über Schraubverbindungen verbunden. Anschlüsse für Gleich- und Drehstrom sind in einer Seitenwand des Gehäuses vorgesehen.

Aus EP-A-1 119 899 ist ein mehrphasiger Umrichter bekannt geworden, der einen Hohlkörper als Träger aufweist, der innen zylindrisch und außen sechseckig ist. An den äußeren Flächen sind Leistungsbauelemente angebracht, die ihrerseits Platinen tragen mit der Steuerelektronik. Um diese Anordnung ist eine zylindrische Umhüllung angeordnet, durch welche die Anschlüsse für Gleich- und Drehstrom hindurchgeführt sind. Im Inneren des Trägers, der gleichzeitig als Kühlkörper ausgeführt ist, ist ein Kondensator angeordnet.

Der Erfindung liegt die Aufgabe zugrunde, ein Antriebssystem mit Umrichtersteuerung für Drehstrommotoren zu schaffen, bei dem bei relativ geringem Herstellungsaufwand eine hohe Leistungsdichte erzielt wird.

Diese Aufgabe wird durch die Merkmale des Patentanspruchs 1 gelöst.

Bei dem erfindungsgemäßen Antriebssystem weist der Leistungsteil wie im bekannten Fall eine erste Leiterplatte auf, die aus gut wärmeleitendem Material besteht und die in flächiger Anlage auf dem gut wärmeleitenden Boden des Gehäuses angeordnet sind. Das Material der ersten Leiterplatte ist zwar elektrisch isolierend, jedoch so beschaffen, daß eine gute Wärmeleitfähigkeit besteht. So kann die erste Leiterplatte aus einem kunststoffgebundenen Aluminiumpulver bestehen, wodurch Wärme in flächigem Kontakt zum gut wärmeleitenden Boden des Gehäuses abgeben kann. Die Leiterbahnen in der ersten Leiterplatte können so angeordnet sein, daß sie ihrerseits Flächenkontakt zum Boden des Gehäuses haben. In diesem Fall darf der Gebäudeboden nicht elektrisch leiten. Das Gehäuse kann aus einem gut wärmeleitenden Material bestehen, beispielsweise Aluminium, das im Druckgußverfahren geformt wird.

Auf der ersten Leiterplatte sind die Leistungstransistoren angeordnet sowie eine Reihe von Kontakt- oder Verbindungsstiften, die auf der Leiterplatte aufgelötet sind und die die erste Leiterplatte mit der zweiten Leiterplatte nicht nur elektrisch, sondern auch mechanisch verbinden, die oberhalb der ersten Leiterplatte parallel zu dieser und im Abstand angeordnet ist. Auf der zweiten Leiterplatte befindet sich der sogenannte Ansteuerteil für die Leistungstransistoren sowie die erforderliche Kondensatorbatterie. Hierbei wird Bezug genommen auf die Offenbarung der DE 199 10 787, wo eine Brückenschaltung für einen Umformer dargestellt ist. Die zweite Leiterplatte besteht aus einem anderen Basismaterial, beispielsweise aus glasfaserverstärktem Kunststoff, das z. B. Kupfereinlagen aufweist oder dergleichen. Die Kontaktstifte erstrecken sich durch Öffnungen der zweiten Leiterplatte und werden vorzugsweise in diesen Öffnungen verlötet, so daß auf diese Weise die mechanisch feste Verbindung hergestellt ist. Die Anordnung aus erster und zweiter Leiterplatte ist als Sandwich-Baueinheit ausgebildet, die vorzugsweise mittels Verschraubung am Boden des Gehäuses befestigt werden kann.

An der ersten Leiterplatte befinden sich auch die Anschlußpunkte für die Drehstrom- und Gleichstromanschlüsse, wobei Anschlußstifte vorgesehen sind, die mit diesen Anschlüssen verbunden und die über Öffnungen in der zweiten Leiterplatte und im Deckel des Gehäuses hindurchgeführt sind.

Ein Umformer der angegebenen Art benötigt darüber hinaus einen sogenannten Steuerteil, der vorzugsweise ebenfalls innerhalb des Gehäuses angeordnet ist, und zwar an der Unterseite des Deckels, wobei das Steuerteil über ein Kabel, beispielsweise ein Flachbandkabel mit der Schaltung der zweiten Leiterplatte verbunden ist. Mit der letzteren Maßnahme ist eine Normierung der Schnittstelle zum Steuerteil geschaffen. Der Leistungsteil kann durch Bestückungsänderung für unterschiedliche Spannungsklassen zur Verfügung gestellt werden.

Mit Hilfe der Erfindung läßt sich die erste Leiterplatte vollautomatisch fertigen, insbesondere im sogenannten SMD (Service Mounted Device) durchführen. Auch die zweite Leiterplatte kann weitgehend automatisch bestückt werden.

Die erfindungsgemäße Ausgestaltung des Antriebssystems mit Umformerteil ermöglicht eine außerordentlich gute Wärmeabfuhr der Leistungstransistoren und damit eine hohe Leistungsdichte, was zu einer entsprechenden Platzeinsparung und kompakten Bauweise führt.

Die Kontaktstifte sind aus einem federnd nachgebenden Material und können im unteren Bereich eine Ausbiegung oder eine andere Formgebung haben derart, daß die Kontaktstifte bei axialer Belastung federnd nachgeben. So können die Kontaktstifte im unteren Bereich beispielsweise eine S-Form aufweisen.

Nach einer anderen Ausgestaltung der Erfindung weisen die Kontaktstifte zwischen den Enden eine Erweiterung auf, auf denen ein Rahmen zwischen erster und zweiter Leiterplatte aufgelagert ist, wobei die Stifte sich durch Öffnungen des Rahmens nach oben erstrecken. Der Rahmen hat eine Stabilisierungs- und Ausrichtfunktion, so daß die oberen Enden der Kontaktstifte in der vorgeschriebenen relativ maßgenauen Anordnung sind, wenn die zweite Leiterplatte aufgesetzt wird. Auf diese Weise ist es möglich, die zweite Leiterplatte vollautomatisch anzubringen, wobei die oberen Enden der Kontaktstifte durch die Öffnungen in der zweiten Leiterplatte hindurch stehen und darin verlötet werden.

Nach einer anderen Ausgestaltung der Erfindung sind die Anschlußpunkte auf der ersten Leiterplatte von Sockeln oder Zapfen gebildet, die flächig auf der ersten Leiterplatte aufgelötet sind, beispielsweise in der SMD-Technik. Die Anschlußstifte weisen einen Hülsenabschnitt auf, der auf den Sockel aufsteckbar ist. Dadurch, daß der Anschlußstift auf den Sockel aufgesteckt wird, kann der Stift sowohl in Dreh- als auch in axialer Richtung nachgeben, so daß am Anschlußstift angreifende Kräfte nicht auf die erste Leiterplatte übertragen werden. Zur besseren mechanischen Befestigung der Anschlußstifte im Deckel sieht eine Ausgestaltung der Erfindung vor, daß ein Abschnitt des Deckels aus Kunststoff besteht, in dessen Öffnungen die oberen Enden der Anschlußstifte festgelegt sind. Vorzugsweise ist dieser Kunststoffabschnitt in einer Ausnehmung oder Vertiefung des Deckels eingegossen. Die Anschlußstifte können einen radialen Flansch aufweisen, der in eine Ausnehmung des Deckelabschnitts drehfest eingreift. Ein Gewindering kann mit einem Außengewinde mit einem Innengewinde der Ausnehmung zusammenwirken und den Flansch gegen den Boden der Ausnehmung festspannen. Um ein Rückdrehen des Gewinderings zu vermeiden, kann dieser mit einer äußeren Zahnung versehen werden, vorzugsweise einer Sägezahnung, die mit der Wand der Ausnehmung im Deckelabschnitt zusammenwirkt, um eine Rückdrehung zu vermeiden.

Die Erfindung soll nachfolgend anhand eines Ausführungsbeispiels näher erläutert werden.
- Fig. 1: zeigt perspektivisch aufgebrochen eine Umformereinheit nach der Erfindung.
- Fig. 2: zeigt die Einheit nach Fig. 1 in auseinandergezogene Darstellung ebenfalls perspektivisch.
- Fig. 3: zeigt perspektivisch die Sandwich-Einheit aus erster und zweiter Leiterplatte der Umformereinheit nach den Fign. 1 und 2.
- Fig. 4: zeigt perspektivisch die Unterseite des Deckels der Einheit nach Fig. 1 oder 2.
- Fig. 5: zeigt die Draufsicht auf die erste Leiterplatte der Sandwich-Einheit nach Fig. 3.
- Fig. 6: zeigt perspektivisch die erste Leiterplatte nach Fig. 5.
- Fig. 7: zeigt einen Schnitt durch die Leiterplatte nach Fig. 5 entlang der Linie 7-7.
- Fig. 8: zeigt einen Teilschnitt durch erste und zweite Leiterplatte der Sandwich-Einheit nach Fig. 3.
- Fig. 9: zeigt die Draufsicht auf einen Teil des Deckels der Umfordereinheit nach Fig. 1 oder 2.
- Fig. 10: zeigt einen Schnitt durch die Darstellung nach Fig. 9 entlang der Linie 10-10.

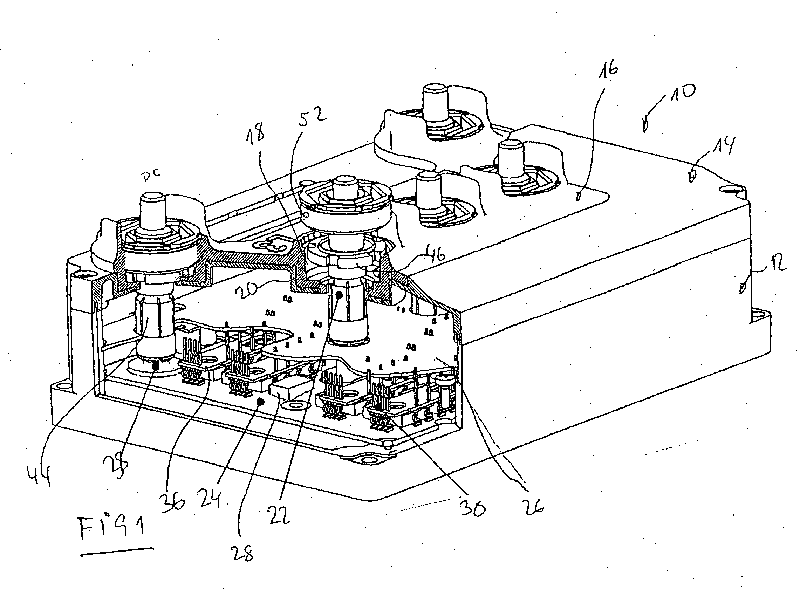

In Fig. 1 ist ein Antriebssystem mit Umformer allgemein mit 10 bezeichnet. Es weist ein Gehäuse auf mit einem Gehäuseunterteil 12 und einem Deckel 14. Der Deckel wirkt dichtend mit dem Gehäuseunterteil 12 zusammen, wobei der Deckel 14 mit dem Unterteil 12 verschraubt wird, worauf jedoch im einzelnen nicht eingegangen wird.

Gehäuseunterteil 12 und Deckel 14 sind z. B. aus Aluminiumdruckguß geformt, insbesondere jedoch aus einem gut wärmeleitendem Material. In einer oberen Ausnehmung oder Vertiefung des Deckels 14 ist ein Abschnitt 16 aus Kunststoff eingespritzt. Der Abschnitt 16 weist fünf Ausnehmungen oder Vertiefungen auf, von denen eine bei 18 besonders gut zu erkennen ist. Der Boden der Ausnehmung 18 weist eine Öffnung auf, die mit einer Öffnung in einer Absenkung 20 des Deckels 14 korrespondiert. Durch diese Öffnungen erstreckt sich ein Anschlußstift 22 nach oben. Es sind insgesamt fünf Anschlußstifte 22 vorgesehen. Die in Fig. 1 am linken Rand des Deckels 14 angeordneten beiden Anschlußstifte bilden den Anschluß für Gleichstrom, der von einer Batterie (nicht gezeigt) geliefert wird. Die drei in Reihe parallel dazu angeordneten Anschlußstifte 22 bilden die Drehstromausgänge, die mit einem nicht gezeigten Drehstommotor eines Fluförderzeugs verbunden werden. Die Befestigung der Anschlußstifte 22 wird nachfolgend noch beschrieben werden. Der mit dem Bezugszeichen 22 versehene Anschlußstift bzw. seine Befestigung ist in einer Montagephase dargestellt, d. h. die hierfür verwendeten Teile sind noch nicht an ihrem endgültigen Platz, wie das in Verbindung mit den anderen Kontaktstiften gezeigt ist.

In Fig. 1 ist eine erste Leiterplatte 24 zu erkennen und eine zweite Leiterplatte 26, die parallel und im Abstand oberhalb der ersten Leiterplatte 24 angeordnet ist.

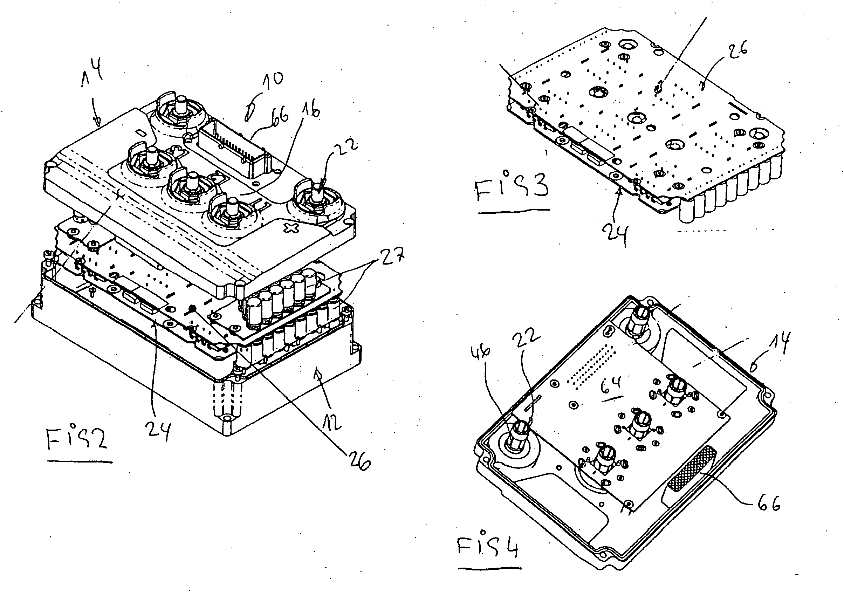

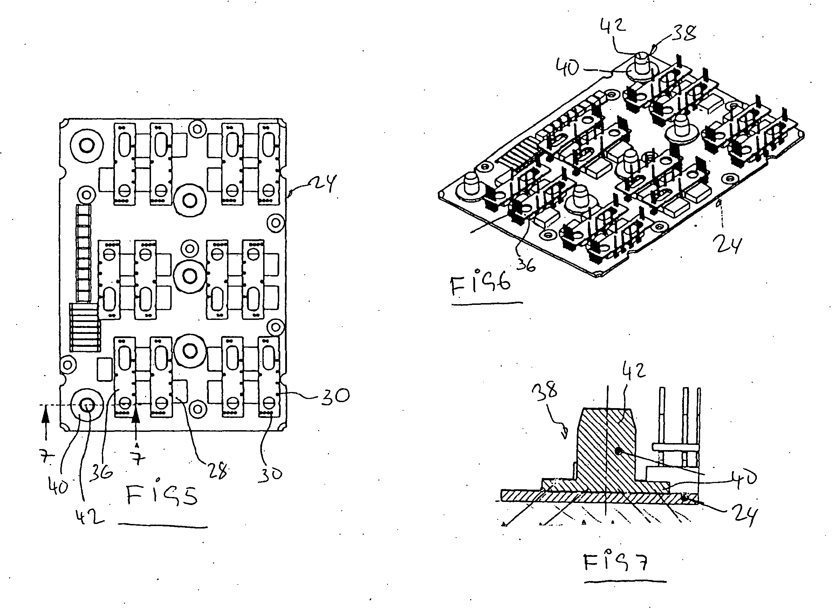

Wie aus den Fign. 2 und 3 hervorgeht, bilden die Leiterplatten 24, 26 eine Sandwich-Einheit. Das Substratmaterial der Leiterplatte 24 besteht z. B. aus kunststoffgebundenem Aluminium, während das für die Leiterplatte 26 aus glasfaserverstärktem Kunststoff besteht. Insbesondere die erste Leiterplatte 24 ist gut wärmeleitend. Sie wird, wie dies aus Fig. 1 zu erkennen ist, flächig auf den Boden des Gehäuseteils 12 aufgelegt, so daß eine gute Wärmeabfuhr erzielbar ist, denn die erste Leiterplatte 24 enthält den Leistungsteil des Umformers, insbesondere die Leistungstransistoren, die, wie z. B. bei 28 in Form von Kästchen angedeutet sind, auf der Leiterplatte 24 aufgelötet sind. Auf der ersten Leiterplatte 24 sind auch Kontaktstifte aufgelötet, und zwar gruppenweise oder einzeln, wie bei 30 zu erkennen. Die Anbringung der Kontaktstifte und deren Form geht deutlicher aus Fig. 8 hervor. Die aus Blech geformten flachen Kontaktstifte 30 sind am unteren Ende S-förmig gebogen, wobei der unteren Schenkel des S über eine größere Strecke flächig auf die Leiterplatte 24 aufgelötet ist. Oberhalb der S-Form weisen die Kontaktstifte 30 eine Erweiterung 34 auf, auf denen ein Rahmen 36 ruht, durch dessen Löcher sich die Kontaktstifte 30 nach oben erstrecken. Derartige Rahmen sind etwa in den Fign. 1, 5 und 6 zu erkennen. Diese Rahmen haben die Aufgabe, die zahlreichen Kontaktstifte einer Kontaktstiftanordnung in einer bestimmten Ausrichtung zu halten, denn die obere Leiterplatte 26 wird so angeordnet, daß sich die oberen Enden der Kontaktstifte 30 durch entsprechende Löcher der Leiterplatte 26 hindurch erstrecken, wie dies in Fig. 8 aber auch in Fig. 1 deutlich zu erkennen ist. Die Kontaktstifte 30 werden mit der oberen Leiterplatte 26 in bekannter Weise verlötet, wobei entsprechende Verbindungen mit den Leiterbahnen der zweiten Leiterplatte 26 hergestellt werden. Die Kontaktstifte 30 sind mit Leiterbahnen der ersten Leiterplatte 24 verbunden, die ihrerseits zu den Transistoren geführt sind. Auf diese Weise ist die zweite Leiterplatte 26 nicht nur elektrisch, sondern auch mechanisch mit der ersten Leiterplatte 24 verbunden zur Bildung der Sandwich-Einheit gemäß den Fign. 2 und 3. Die besondere Form der Kontaktstifte 30 ermöglicht eine schwingungsdämpfende Auflagerung der zweiten Leiterplatte 26, so daß Schwingungen nicht unmittelbar auf die Lötstellen einwirken.

Auf der ersten Leiterplatte 24 sind fünf Sockel 38 angeordnet. Sie weisen einen Flansch 40 auf, der flächig mit der ersten Leiterplatte 24 verlötet ist. Vom Flansch 40 nach oben erstreckt sich ein Zapfen 42. Die Sockel 38 bilden die Anschlüsse für die Anschlußstifte 22 für Gleich- und Wechselstrom. Sowohl die Transistoren als auch die Sockel 38 können mit einer sogenannten SMD (Service Mounted Device) Technik mit der ersten Leiterplatte 24 verbunden werden, was voll automatisch vonstatten gehen kann. Die zweite Leiterplatte 26 enthält den sogenannten Ansteuerteil für die Leistungshalbleiter, wobei die zweite Leiterplatte ebenfalls nahezu voll automatisch im SMD-Verfahren hergestellt werden kann. Auf die Bestückung der zweiten Leiterplatte wird nicht weiter eingegangen. Es sei aber auf die Kondensatoren 27 hingewiesen. Die unteren sind an der zweiten Leiterplatte angebracht und die oberen auf zwei Extraplatinen, die mittels Schraubverbindung mechanisch und elektrisch mit der zweiten Leiterplatte verbunden sind.

Wie insbesondere aus Fig. 10 zu erkennen, hat der Anschlußstift 22 am unteren Ende ein Hülsenteil 44, das so ausgebildet ist, daß es auf den Zapfen 42 aufsteckbar ist, um eine elektrische Verbindung herzustellen. Hierzu kann der Hülsenteil 44 entsprechend geformt werden, was jedoch im einzelnen nicht beschrieben werden soll. Oberhalb des Hülsenteils 44 ist der Anschlußstift 22 massiv, und zwischen den Enden weist er einen Flansch 46 auf. Der Flansch 46 ist oberhalb einer Öffnung in der Ausnehmung 18 des Deckelabschnitts 16 bzw. einer Öffnung im Deckel 14. Oberhalb dieser Öffnung befindet sich, wie bereits beschrieben, die Ausnehmung 18, die annähernd kreisförmig ist und im unteren Teil mit fünf im gleichmäßigen Umfangsabstand angeordneten radialen Vorsprüngen 48 versehen ist, die mit entsprechend geformten Ausnehmungen 50 des Flansches 46 zusammenwirken, um diesen gegen Drehung zu sichern (siehe insbesondere Fig. 9). Die Festlegung des Anschlußstiftes 22 im Deckelabschnitt 16 erfolgt mit Hilfe eines Gewindespannringes 52, der ein Außengewinde 54 aufweist, das mit einem Innengewinde 56 in der Ausnehmung 18 zusammenwirkt. Dadurch kann der Flansch 46 gegen den Boden der Ausnehmung gespannt und auch in seiner Drehlage festgelegt werden. Der Spannring 52 weist am oberen Ende einen radialen nach außen weisenden Flansch 58 auf, der, wie in Fig. 9 zu erkennen, eine Sägezahnung 60 aufweist. Die Sägezahnung wirkt mit der gegenüberliegenden Wand der Ausnehmung 18 zusammen, wodurch der Spannring 52 gegen Drehung gesichert ist und sich nicht selbsttätig lösen kann.

Man erkennt aus den Fign. 9 und 10, daß alle am Kontaktstift 22 angreifenden Kräfte, wie Axial- und Biegekräfte aber auch Drehmomente, wie sie z. B. bei der Anbringung eines Kabelschuhes auftreten, nicht auf den Anschlußsockel 38 übertragen werden, so daß die Lötverbindung nicht gefährdet wird.

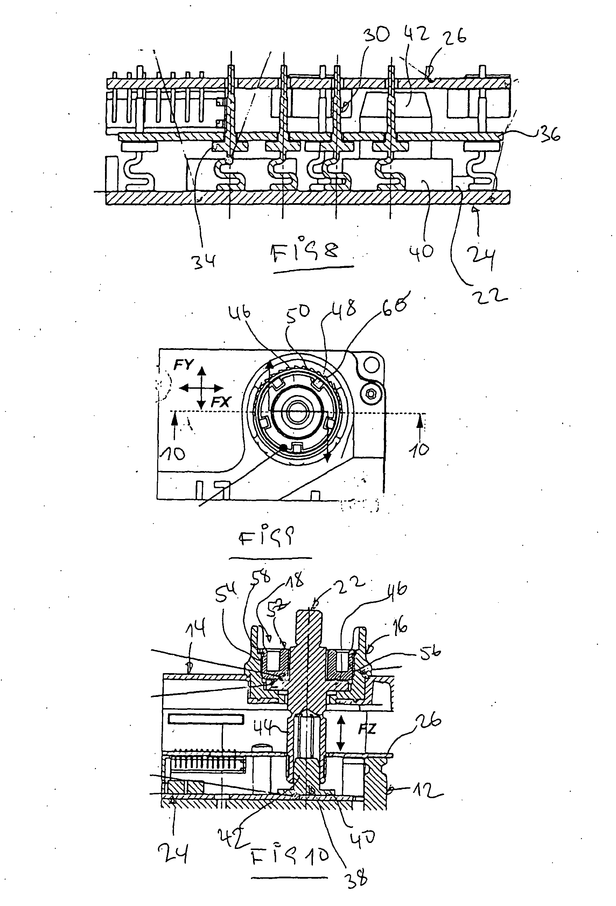

Wie aus Fig. 4 zu erkennen ist, ist mit der Unterseite des Deckels 14 durch Verschraubung eine dritte Leiterplatte 64 befestigt. Diese dritte Leiterplatte 64 enthält den Steuerteil für den Ansteuerteil, der sich auf der zweiten Leiterplatte 26 befindet. Am Deckel 14 ist auch ein Anschluß für ein Flachbandkabel (nicht gezeigt) angebracht. Der Anschluß ist über ein Flachbandkabel elektrisch mit der zweiten Leiterplatte 26 verbunden (nicht im einzelnen gezeigt). An der zweiten Leiterplatte 26 befindet sich ein analoger Anschluß (nicht gezeigt), um über das nicht gezeigte Flachbandkabel eine Verbindung zwischen Steuer- und Ansteuerteil auf dritter und zweiter Leiterplatte 64, 26 herzustellen. 66 dient dem Wärmeabfluß eines Schaltungsteils der darunter liegenden Platine 26 als eine Art Kühler.

Die Befestigung des Deckels 14 am Gehäuseteil 12 erfolgt, wie bereits beschrieben, mittels einer Verschraubung. Auch die Sandwich-Einheit aus erster und zweiter Leiterplatte gemäß Fig. 3 wird mit Hilfe von Schrauben am Boden des Gehäuseteils 12 befestigt.

Mit dem beschriebenen Umformersystem wird eine Reihe von Vorteilen erhalten. So läßt sich das Leistungsmodul, das auf IMS-Basis erstellt ist, vollständig automatisch mit Hilfe der SMD-Technologie bestücken. Auch die zweite Leiterplatte 26 läßt sich größtenteils mittels SMD bestücken. Das aus erster und zweiter Leiterplatte hergestellte Sandwich ermöglicht eine optimale Raumausnutzung. Die beschriebene Anbindung der Leistungsanschlüsse ist thermisch optimal. Ferner wird eine mechanische Entkopplung und Adaptierung der Sandwich-Einheit über das beschriebene Stecksystem erhalten, wobei auch ein Ausgleich aller horizontalen und vertikalen Toleranzen erzielt wird. Drehmomente, die an den Anschlußstiften auftreten, werden vom Deckel aufgenommen und gelangen nicht auf die Sandwich-Einheit. Zwischen Leiterplatte und Ansteuerleiterplatte findet eine schwingungsgedämpfte und thermische Entkopplung statt. Außerdem wird bei der Erfindung die sogenannte EMV-Störaussendung reduziert und die EMV-Einstrahlfestigkeit optimiert.

## Patentansprüche

1. Antriebssystem mit Umrichtersteuerung von Niederspannungs-Drehstrommotoren, das einen Transistoren und Kondensatoren enthaltenen Leistungsteil, einen Ansteuerteil für die Transistoren und einen Steuerteil aufweist sowie Anschlüsse für Gleich- und Drehstrom, wobei die Teile in einem gemeinsamen Gehäuse aus wärmeleitendem Material angeordnet sind, wobei der Leistungsteil eine erste Leiterplatte (24) aus gut wärmeleitendem Material aufweist, die in flächiger Anlage auf dem gut wärmeleitenden Boden des Gehäuses (12) angeordnet ist, und wobei eine zweite Leiterplatte (26) den Ansteuerteil enthält, die mit Hilfe von an der ersten Leiterplatte (24) angelöteten Kontaktstiften (30) aus metallischem Material die zweite Leiterplatte (26) im Abstand zur ersten Leiterplatte (24) mit dieser elektrisch verbunden ist, und Anschlüsse für Gleich- und Drehstrom im Gehäuse (12) mit der Leiterplatte (24) verbunden sind,
**dadurch gekennzeichnet, daß** die Kontaktstifte (30) mechanisch fest mit der zweiten Leiterplatte (26) verbunden sind zur Bildung einer Sandwich-Baueinheit mit der ersten Leiterplatte (24), die Kontaktstifte (30) aus einem federnden Material bestehen und eine Formgebung aufweisen, daß sie axial federnd nachgeben und Anschlußstifte (22) mit Anschlußpunkten (38) der ersten Leiterplatte (24) verbunden und über Öffnungen in der zweiten Leiterplatte (26) sowie in einem Deckel des Gehäuses (12) isoliert herausgeführt sind.

2. Antriebssystem nach Anspruch 1, **dadurch gekennzeichnet, daß** eine dritte den Steuerteil enthaltende Leiterplatte (64) mit der Unterseite des Deckels (14) des Gehäuses (12) mechanisch und elektrisch über ein Kabel mit der zweiten Leiterplatte (26) verbunden ist.

3. System nach Anspruch 1 oder 2, **dadurch gekennzeichnet, daß** die Leiterbahnen der ersten Leiterplatte (24) am Boden des Gehäuses (12) anliegen.

4. System nach einem der Ansprüche 1 bis 3, **dadurch gekennzeichnet, daß** Gehäuse (12) und Deckel (14) aus Aluminium geformt sind.

5. System nach einem der Ansprüche 1 bis 4, **dadurch gekennzeichnet, daß** die Kontaktstifte (30) auf der ersten Leiterplatte (24) aufgelötet und am oberen Ende in Löchern der zweiten Leiterplatte festgelötet sind.

6. System nach Anspruch 5, **dadurch gekennzeichnet, daß** die Kontaktstifte (30) nahe der Anbringung axial nachgebend geformt sind, vorzugsweise durch eine Ausbiegung oder dergleichen.

7. System nach Anspruch 6, **dadurch gekennzeichnet, daß** die Kontaktstifte (30) im unteren Bereich annähernd eine S-Form aufweisen.

8. System nach Anspruch 6 oder 7, **dadurch gekennzeichnet, daß** die Kontaktstifte (30) zwischen den Enden eine Erweiterung (34) aufweisen, auf denen ein Rahmen (36) zwischen erster und zweiter Leiterplatte (24, 26) auflagerbar ist, wobei die Kontaktstifte (30) sich durch Öffnungen des Rahmens (36) nach oben erstrecken.

9. System nach einem der Ansprüche 2 bis 8, **dadurch gekennzeichnet, daß** die elektrische Verbindung zwischen zweiter und dritter Leiterplatte (26, 64) mittels eines Flachbandkabels erfolgt.

10. System nach einem der Ansprüche 1 bis 9, **dadurch gekennzeichnet, daß** die Anschlußstifte (22) relativ zu den Anschlußpunkten (38) begrenzt bewegbar und mechanisch in Öffnungen des Deckels (14) festgelegt sind.

11. System nach einem der Ansprüche 1 bis 10, **dadurch gekennzeichnet, daß** die Anschlußpunkte von Sockeln (38) gebildet sind, die flächig auf der ersten Leiterplatte (24) aufgelötet sind und die Anschlußstifte (22) einen Hülsenabschnitt (44) aufweisen, der auf einen Sockel (42) aufsteckbar ist.

12. System nach einem der Ansprüche 1 bis 11, **dadurch gekennzeichnet, daß** ein Abschnitt (16) des Deckels (14) aus Kunststoff besteht, in dessen Öffnungen die oberen Enden der Anschlußstifte (22) festgelegt sind.

13. System nach Anspruch 12, **dadurch gekennzeichnet, daß** der Abschnitt (16) in einer Ausnehmung des Deckels (14) angeordnet ist, vorzugsweise im Kunststoff-Einspritzverfahren.

14. System nach Anspruch 12 oder 13, **dadurch gekennzeichnet, daß** die Anschlußstifte (22) einen radialen Flansch (46) aufweisen, der in einer Ausnehmung (18) des Deckelabschnitts (16) drehfest eingreift und ein Gewindering (52) mit einem Gewinde in der Ausnehmung (18) zusammenwirkt und gegen den Flansch (46) zur Anlage bringbar ist.

15. System nach Anspruch 14, **dadurch gekennzeichnet, daß** der Gewindering (52) einen äußeren Flansch (58) aufweist, der eine Sägezahnform (60) am Umfang hat, die mit einem Innenabschnitt der Ausnehmung (18) zusammenwirkt, um den Ring (52) gegen Drehung zu sichern.

16. System nach einem der Ansprüche 12 bis 15, **dadurch gekennzeichnet, daß** die Ausnehmung (18) im Deckelabschnitt (16) in einem nach unten weisenden Vorsprung des Deckelabschnitts (16) gebildet ist, der seinerseits in eine Vertiefung des Deckels (14) eingreift.

## Claims

1. Driving system with converter control for low voltage three-phase motors, which is provided with a power unit containing transistors and capacitors, a triggering unit for the transistors and a control unit as well as connections for direct and three-phase current, wherein the units are disposed in a common casing made of a heat-conductive material, wherein the power unit is provided with a first printed circuit board (24) made of fairly heat-conductive material, which is disposed on the fairly heat-conductive bottom of the casing (12) in a plane fitting arrangement, and wherein a second printed circuit board (26) contains the triggering unit, the second printed circuit board (26) being electrically connected to the first printed circuit board (24) in a spacing to it with the aid of contact pins (30) of metallic material attached on the first printed circuit board (24) by soldering, and connections (22) for direct current and three-phase current in the casing (12) are connected to the printed circuit board (24), **characterized in that** the contact pins (30) are mechanically fixed to the second printed circuit board (26) to form a sandwich assembly with the first printed circuit board (24), the contact pins (30) consist of a resilient material and have a shaping such that they are axially resiliently yielding, and terminal pins (22) are connected to contact points (38) of the first printed circuit board (24) and are led out via openings in the second printed circuit board (26) and in a cover of the casing (12) in an insulated manner.

2. Driving system according to claim 1, **characterised in that** a third printed circuit board (64) containing the control unit is mechanically coupled with the bottom side of a cover (14) of the casing (12) and is electrically connected to the second printed circuit board (26) via a cable.

3. System according to claim 1 or 2, **characterised in that** the interconnection traces of the first printed circuit board (24) abut the bottom of the casing (12).

4. System according to any of claims 1 to 3, **characterised in that** casing (12) and cover (14) are formed from aluminium.

5. System according to any of claims 1 to 4, **characterised in that** the contact pins (30) are soldered on the first printed circuit board (24) and are fixedly soldered into holes of the second printed circuit board on their upper ends.

6. System according to claim 5, **characterised in that** the contact pins (30) are formed axially yielding in the vicinity of its mounting, preferably by an outward bend or the like.

7. System according to claim 6, **characterised in that** the contact pins (30) are approximately s-shaped in the bottom region.

8. System according to claim 6 or 7, **characterised in that** the contact pins (30) have an enlargement (34) between the ends, a frame (36) between the first and the second printed circuit board (24, 26) being supportable on it, the contact pins (30) extending into the upward direction through openings in the frame (36).

9. System according to any of claims 2 to 8, **characterised in that** the electrical connection between second and third printed circuit board (26, 64) takes place via a flat ribbon cable.

10. System according to any of claims 1 to 9, **characterised in that** the terminal pins (22) are movable in a delimited way with respect to the points of connection (38) and are mechanically fixed in openings of the cover (14).

11. System according to any of claims 1 to 10, **characterised in that** the contact points are formed by sockets (38), which are soldered on the first printed circuit board (24) in a plane-fitting manner, and that the terminal pins (22) have a sleeve portion (44) which is pushable up to a socket (42).

12. System according to any of claims 1 to 11, **characterised in that** a portion (16) of the cover (14) consists of plastic material, in the openings of which are fixedly attached the upper ends of the terminal pins (22).

13. System according to claim 12, **characterised in that** the portion (16) is disposed in a recess of the cover (14), preferably by the plastic material injection moulding method.

14. System according to claim 12 or 13, **characterised in that** the terminal pins (22) are provided with a radial flange (46), which engages into a recess (18) of the cover portion (16) in a rotatably fixed manner, and that a ring nut (52) co-operates with a thread in the recess (18) and can be brought into bearing with the flange (46).

15. System according to claim 14, **characterised in that** the ring nut (52) is provided with an outer flange (58) which has a saw-tooth form (60) on its perimeter which co-operates with an interior portion of the recess (18) in order to secure the ring (52) against rotation.

16. System according to any of claims 12 to 15, **characterised in that** the recess (18) in the cover portion (16) is formed in a downward-directed projection of the cover portion (16), which on its part engages into an indentation of the cover (14).

## Revendications

1. Système d'entraînement avec commande de convertisseur pour moteurs triphasés basse tension, présentant une partie de puissance contenant des transistors et des condensateurs, une partie de pilotage pour les transistors et une partie de commande, ainsi que des connexions pour le courant continu et triphasé, les parties étant disposées dans un boîtier commun fait d'un matériau conducteur de chaleur, la partie de puissance présentant une première carte de circuit imprimé (24) faite d'un matériau bon conducteur de chaleur et disposée en appui à plat sur le fond bon conducteur de chaleur du boîtier (12), et une deuxième carte de circuit imprimé (26) contenant la partie de pilotage, la deuxième carte de circuit imprimé (26) étant reliée électriquement, à l'aide de broches de contact (30) faites d'un matériau métallique soudées à la première carte de circuit imprimé (24), à la première plaque de circuit imprimé (24) à distance de celle-ci, et des connexions pour le courant continu et triphasé dans le boîtier (12) étant reliées à la carte de circuit imprimé (24),
**caractérisé en ce que**
les broches de contact (30) sont reliées mécaniquement de façon fixe à la deuxième carte de circuit imprimé (26) pour former une unité en sandwich avec la première carte de circuit imprimé (24), les broches de contact (30) se composent d'un matériau élastique et présentent une mise en forme leur permettant de se courber axialement de façon élastique et **en ce que** des broches de connexion (22) sont reliées à des points de connexion (38) de la première carte de circuit imprimé (24) et sont guidées vers l'extérieur de façon isolée via des ouvertures dans la deuxième carte de circuit imprimé (26) ainsi que dans un couvercle du boîtier (12).

2. Système d'entraînement selon la revendication 1,
**caractérisé en ce qu'**
une troisième carte de circuit imprimé (64) contenant la partie de commande est reliée mécaniquement à la face inférieure du couvercle (14) du boîtier (12) et électriquement, via un câble, à la deuxième carte de circuit imprimé (26).

3. Système selon la revendication 1 ou 2,
**caractérisé en ce que**
les pistes conductrices de la première carte de circuit imprimé (24) se situent au niveau du fond du boîtier (12).

4. Système selon l'une des revendications 1 à 3,
**caractérisé en ce que**
le boîtier (12) et le couvercle (14) sont formés en aluminium.

5. Système selon l'une des revendications 1 à 4,
**caractérisé en ce que**
les broches de contact (30) sont soudées sur la première carte de circuit imprimé (24) et sont soudées au niveau de leur extrémité supérieure dans des trous de la deuxième carte de circuit imprimé.

6. Système selon la revendication 5,
**caractérisé en ce que**
les broches de contact (30) sont formées de manière à se courber axialement lors du montage, de préférence par flexion ou analogue.

7. Système selon la revendication 6,
**caractérisé en ce que**
les broches de contact (30) présentent dans la zone inférieure approximativement une forme de S.

8. Système selon la revendication 6 ou 7,
**caractérisé en ce que**
les broches de contact (30) présentent entre leurs extrémités un élargissement (34) sur lequel un cadre (36) peut être monté entre la première et la deuxième carte de circuit imprimé (24, 26), les broches de contact (30) s'étendant vers le haut à travers des ouvertures du cadre (36).

9. Système selon l'une des revendications 2 à 8,
**caractérisé en ce que**
la liaison électrique entre la deuxième et la troisième carte de circuit imprimé (26, 64) s'effectue au moyen d'un câble ruban.

10. Système selon l'une des revendications 1 à 9,
**caractérisé en ce que**
les broches de connexion (22) sont mobiles de façon limitée par rapport aux points de connexion (38) et sont fixées mécaniquement dans des ouvertures du couvercle (14).

11. Système selon l'une des revendications 1 à 10,
**caractérisé en ce que**
les points de connexion sont formés par des socles (38) soudés à plat sur la première carte de circuit imprimé (24) et les broches de connexion (22) présentent une section de douille (44) pouvant être insérée sur un socle (42).

12. Système selon l'une des revendications 1 à 11,
**caractérisé en ce qu'**
une section (16) du couvercle (14) se compose de matière plastique, et présente des ouvertures dans lesquelles sont fixées les extrémités supérieures des broches de connexion (22).

13. Système selon la revendication 12,
**caractérisé en ce que**
la section (16) est disposée dans un évidement du couvercle (14), de préférence dans le cadre d'un procédé d'injection de matière plastique.

14. Système selon la revendication 12 ou 13,
**caractérisé en ce que**
les broches de connexion (22) présentent une bride radiale (46) qui s'engage de manière non rotative dans un évidement (18) de la section de couvercle (16) et une bague filetée (52) coopère avec un filetage dans l'évidement (18) et peut être amenée en appui contre la bride (46).

15. Système selon la revendication 14,
**caractérisé en ce que**
la bague filetée (52) présente une bride extérieure (58) qui possède sur sa périphérie une forme en dents de scie (60), qui coopère avec une section intérieure de l'évidement (18) pour fixer la bague (52) de façon à empêcher toute rotation.

16. Système selon l'une des revendications 12 à 15,
**caractérisé en ce que**
l'évidement (18) dans la section de couvercle (16) est formé dans une saillie tournée vers le bas de la section de couvercle (16), qui s'engage pour sa part dans un renfoncement du couvercle (14).
